# EUROPÄISCHE PATENTSCHRIFT

(11) **EP 2 238 634 B1**
(45) Veröffentlichungstag und Bekanntmachung des Hinweises auf die Patenterteilung: **04.03.2020**
(21) Anmeldenummer: 09706825.8
(22) Anmeldetag: 29.01.2009
(51) Int. Cl.: H01L 51/52

(54) **VERFAHREN ZUR HERSTELLUNG EINES ELEKTRONISCHEN BAUELEMENTS**
METHOD FOR PRODUCING AN ELECTRONIC COMPONENT
PROCÉDÉ POUR PRODUIRE UN COMPOSANT ÉLECTRONIQUE

(30) Priorität: 30.01.2008 DE 102008006721; 21.04.2008 DE 102008019900; 02.07.2008 DE 102008031405; 23.09.2008 DE 102008048472
(43) Veröffentlichungstag der Anmeldung: 13.10.2010
(73) Patentinhaber: OSRAM OLED GmbH, 93049 Regensburg (DE)
(72) Erfinder: SCHMID, Christian, 93049 Regensburg (DE); SCHLENKER, Tilman, 93152 Nittendorf (DE); ZULL, Heribert, 93049 Regensburg (DE); PÄTZOLD, Ralph, 91154 Roth (DE); KLEIN, Markus, 93105 Tegernheim (DE); HEUSER, Karsten, 91056 Erlangen (DE)
(74) Vertreter: Epping - Hermann - Fischer
(86) Internationale Anmeldenummer: PCT/DE2009/000133
(87) Internationale Veröffentlichungsnummer: WO 2009/095005

(56) Entgegenhaltungen:
- EP-A1- 2 857 443
- KR-A- 20050 021 152
- US-A1- 2001 031 379
- US-A1- 2007 020 451
- SANG-HEE KO PARK ET AL: "Ultrathin Film Encapsulation of an OLED by ALD" ELECTROCHEMICAL AND SOLID-STATE LETTERS,, Bd. 8, Nr. 2, 6. Januar 2005 (2005-01-06), Seiten H21-H23, XP002530094
- LIFKA H ET AL: "THIN FILM ENCAPSULATION OF OLED DISPLAYS WITH A NONON STACK" 2004 SID INTERNATIONAL SYMPOSIUM DIGEST OF TECHNICAL PAPERS. SEATTLE, WA, MAY 25 - 27, 2004; [SID INTERNATIONAL SYMPOSIUM DIGEST OF TECHNICAL PAPERS], SAN JOSE, CA : SID, US, Bd. 35, Nr. 2, 26. Mai 2004 (2004-05-26), Seiten 1384-1387, XP001222870
- LANGEREIS E ET AL: "Plasma-assisted atomic layer deposition of Al2O3 moisture permeation barriers on polymers" APPLIED PHYSICS LETTERS, AIP, AMERICAN INSTITUTE OF PHYSICS, MELVILLE, NY, US, Bd. 89, Nr. 8, 25. August 2006 (2006-08-25), Seiten 81915-081915, XP012088600 ISSN: 0003-6951
- YUN SUN ET AL: "Passivation of organic light-emitting diodes with aluminum oxide thin films grown by plasma-enhanced atomic layer deposition" APPLIED PHYSICS LETTERS, AIP, AMERICAN INSTITUTE OF PHYSICS, MELVILLE, NY, US, Bd. 85, Nr. 21, 1. Januar 2004 (2004-01-01), Seiten 4896-4898, XP012063494 ISSN: 0003-6951
- POTSCAVAGE W ET AL: "Encapsulation of pentacene/C60 organic solar cells with Al2O3 deposited by atomic layer deposition" APPLIED PHYSICS LETTERS, AIP, AMERICAN INSTITUTE OF PHYSICS, MELVILLE, NY, US, Bd. 90, Nr. 25, 21. Juni 2007 (2007-06-21), Seiten 253511-253511, XP012095426 ISSN: 0003-6951

## Beschreibung

Diese Patentanmeldung beansprucht die Prioritäten der deutschen Patentanmeldung 10 2008 006 721.0, der deutschen Patentanmeldung 10 2008 019 900.1, der deutschen Patentanmeldung 10 2008 031 405.6 und der deutschen Patentanmeldung 10 2008 048 472.5.

Es werden ein Verfahren zur Herstellung eines elektronischen Bauelements und ein elektronisches Bauelement angegeben.

Für einen dauerhaften Betrieb von elektronischen Bauelementen wie etwa anorganischen lichtemittierenden Dioden (LEDs) oder organischen lichtemittierenden Dioden (OLEDs) ist es oft erforderlich, diese vor Feuchtigkeit zu schützen. Insbesondere kann es erforderlich sein, dass die Bauelemente umfassenden Lebensdauertests unterzogen werden, um sicherzustellen, dass sie im alltäglichen Gebrauch über Jahre ihre Funktionalität bewahren können.

Die Druckschrift KR 10-2005-0021152 beschreibt eine OLED mit einer Schutzschicht, die durch eine mittels plasmaunterstützter chemischer Gasphasenabscheidung hergestellte anorganische Pufferschicht und eine mittels Atomschichtenabscheidung hergestellte anorganische isolierende Schicht gebildet wird. Zwischen der OLED und der Schutzschicht kann eine organische Isolationsschicht angeordnet sein.

Eine Aufgabe von zumindest einer Ausführungsform ist es daher, ein Verfahren zur Herstellung eines elektronischen Bauelements mit einer Verkapselung anzugeben. Weiterhin ist es eine Aufgabe von zumindest einer Ausführungsform, ein elektronisches Bauelement mit einer Verkapselung anzugeben.

Diese Aufgaben werden durch das Verfahren und den Gegenstand des unabhängigen Patentanspruchs 1 gelöst. Vorteilhafte Ausführungsformen und Weiterbildungen des Verfahrens und des Gegenstands sind in den abhängigen Ansprüchen gekennzeichnet und gehen weiterhin aus der nachfolgenden Beschreibung und den Zeichnungen hervor.

Ein Verfahren zur Herstellung eines elektronischen Bauelements mit Barrierenschichten zur Verkapselung des Bauelements gemäß einer Ausführungsform umfasst insbesondere die Schritte:
- Bereitstellen eines Substrats mit zumindest einer funktionellen Schicht,
- Aufbringen zumindest einer ersten Barrierenschicht auf der funktionellen Schicht mittels plasmaunterstützter Atomschichtenabscheidung (PEALD) und
- Aufbringen zumindest einer zweiten Barrierenschicht auf der funktionellen Schicht mittels plasmaunterstützter chemischer Gasphasenabscheidung (PECVD).

Dass eine erste Schicht oder ein erstes Element "auf" oder "über" einer zweiten Schicht oder einem zweiten Element oder auch "zwischen" zwei weiteren Schichten oder Elementen angeordnet oder aufgebracht ist, kann dabei hier und im Folgenden bedeuten, dass die erste Schicht oder das erste Element unmittelbar im direkten mechanischen und/oder elektrischen Kontakt auf der zweiten Schicht oder dem zweiten Element beziehungsweise zu den zwei weiteren Schichten oder Elementen angeordnet ist. Weiterhin kann auch ein mittelbarer Kontakt bezeichnet sein, bei dem weitere Schichten und/oder Elemente zwischen der ersten Schicht oder dem ersten Element und der zweiten Schicht oder dem zweiten Element bzw. den zwei weiteren Schichten oder Elementen angeordnet sind.

Eine chemische Gasphasenabscheidung ("chemical vapor deposition", CVD) kann dabei ein Verfahren bezeichnen, bei dem auf zumindest einer Oberfläche des bereitgestellten Substrats mit der zumindest einen funktionellen Schicht zumindest zwei gasförmige Ausgangsverbindungen zu einem festen Reaktionsprodukt reagieren. Dabei können die zumindest zwei gasförmigen Ausgangsverbindungen gleichzeitig einem Volumen zugeführt werden, in dem das Substrat bereitgestellt wird. Weiterhin kann es erforderlich sein, dass die zumindest eine Oberfläche des bereitgestellten Substrats mit der zumindest einen funktionellen Schicht auf eine Temperatur oberhalb der Raumtemperatur erhitzt wird.

Eine plasmaunterstützte chemische Gasphasenabscheidung ("plasma enhanced chemical vapor deposition", PECVD) kann ein CVD-Verfahren bezeichnen, bei dem in dem Volumen ein Plasma erzeugt wird, wodurch die dem Volumen zugeführten zumindest zwei gasförmigen Ausgangsverbindungen in dem Plasma angeregt werden können. Dadurch kann es möglich sein, dass die Temperatur, auf die die zumindest eine Oberfläche aufgeheizt werden muss, im Vergleich zu einem plasmalosen CVD-Verfahren erniedrigt werden kann. Das kann insbesondere vorteilhaft sein, da die zumindest eine funktionelle Schicht bei einer Temperatur oberhalb einer Maximaltemperatur irreversibel geschädigt werden kann. Die Maximaltemperatur kann beispielsweise etwa 120°C betragen, so dass die Temperatur, bei der die zweite Barrierenschicht aufgebracht wird, kleiner als 120°C und bevorzugt kleiner oder gleich 80°C sein kann.

Eine Atomschichtenabscheidung ("atomic layer deposition", ALD) kann ein Verfahren bezeichnen, bei dem im Vergleich zu einem CVD-Verfahren zuerst eine erste der zumindest zwei gasförmigen Ausgangverbindungen dem Volumen, in dem das Substrat bereitgestellt wird, zugeführt wird und auf der zumindest einen Oberfläche adsorbieren kann. Nach einer bevorzugt vollständigen oder nahezu vollständigen Bedeckung der zumindest einen Oberfläche mit der ersten Ausgangsverbindung kann der Teil der ersten Ausgangsverbindung, der noch gasförmig und/oder nicht auf der Oberfläche adsorbiert vorliegt, wieder aus dem Volumen entfernt werden und die zweite der zumindest zwei Ausgangsverbindung kann zugeführt werden. Die zweite Ausgangsverbindung kann mit der an der zumindest einen Oberfläche adsorbierten ersten Ausgangsverbindung unter Bildung einer festen Schicht reagieren. Wie bei einem CVD-Verfahren kann es vorteilhaft sein, wenn die zumindest eine Oberfläche auf eine Temperatur über der Raumtemperatur erhitzt wird.

Eine plasmaunterstützte Atomschichtabscheidung ("plasma enhanced atomic layer deposition", PEALD) kann ein ALD-Verfahren bezeichnen, bei dem die zweite Ausgangsverbindung bei gleichzeitiger Erzeugung eines Plasmas zugeführt wird, wodurch es wie bei PECVD-Verfahren möglich sein kann, dass die zweite Ausgangsverbindung angeregt wird. Dadurch kann im Vergleich zu einem plasmalosen ALD-Verfahren die Temperatur, auf die die zumindest eine Oberfläche aufgeheizt wird, verringert werden. Die erste Barrierenschicht kann dabei beispielsweise bei einer Temperatur von kleiner als 120°C und bevorzugt kleiner oder gleich 80°C aufgebracht werden. Um eine weitere feste Schicht zu erzeugen, können die Schritte des Zuführens der ersten Ausgangsverbindung und danach des Zuführens der zweiten Ausgangsverbindung wiederholt werden.

Die im Rahmen des hier beschriebenen Verfahrens herstellbare Verkapselung kann im Vergleich zu bekannten Verkapselungen mit Barrierenschichten, die alle durch CVD-Verfahren hergestellt sind, eine geringere Durchlässigkeit für Feuchtigkeit und/oder Sauerstoff aufweisen. Bei Verkapselungen mit Barrierenschichten, die alle durch CVD-Verfahren hergestellt sind, kann es möglich sein, dass Kanäle, Poren und/oder Korngrenzen auftreten, die zu Undichtigkeiten der herkömmlichen Verkapselungen führen können. Derartige Undichtigkeiten können insbesondere dadurch begünstigt werden, dass bei elektronischen Bauelementen die Maximaltemperatur, bei denen Barrierenschichten aufgebracht werden können, wie oben erwähnt, etwa 120°C und bevorzugt etwa 80°C nicht überschreiten darf. Dadurch erfordern herkömmliche Verkapselungen mit CVD-aufgebrachten Barrierenschichten sehr komplexe und damit kostenintensive Vielschichtsysteme, die eine wirtschaftliche Herstellung von elektronischen Bauelementen mit einer Verkapselung verhindern können.

Diese Nachteile herkömmlicher Verkapselungen können durch das hier beschriebene Verfahren vermieden werden. Durch das PEALD-Verfahren zum Aufbringen der ersten Barrierenschicht kann die erste Barrierenschicht im Vergleich zu einer Barrierenschicht, die mittels eines CVD- oder PECVD-Verfahrens aufgebracht wird, mit einer höheren Dichte hergestellt werden und die Ausbildung und/oder Fortsetzung von Kanälen und/oder Poren kann dabei verringert oder verhindert werden. Damit kann im Vergleich zu einer mittels eines CVD-Verfahrens hergestellten Schicht für die erste Barrierenschicht auch eine höhere Dichtigkeit hinsichtlich Feuchtigkeit und/oder Sauerstoff erreicht werden. Dabei kann es möglich sein, dass die Anzahl der Barrierenschichten und/oder ihre Dicke im Vergleich zu Barrierenschichten von Verkapselungen, die mit herkömmlichen CVD-Verfahren hergestellt sind, verringert werden kann. Dadurch kann eine dünne Verkapselung bei gleichzeitig hoher intrinsischer Dichtigkeit auf kleine Flächen wie auch großflächig erzeugt werden und die Diffusion von Feuchtigkeit und/oder Sauerstoff durch Korngrenzen, Kanäle und/oder Poren kann verringert oder verhindert werden. Weiterhin kann die hier beschriebene Verkapselung mit den ersten und zweiten Barrierenschichten auch eine hohe Dichtigkeit in Randbereichen der Verkapselung aufweisen, so dass eine Diffusion von Feuchtigkeit und/oder Sauerstoff durch Grenzflächen zwischen der Verkapselung und dem bereitgestellten Substrat mit der zumindest einen funktionellen Schicht verringert oder verhindert werden kann.

Im Vergleich zu weiterhin bekannten Verkapselungen mittels eines Deckglases, bei dem in eine Kavität zusätzlich ein Gettermaterial eingebracht wird, ermöglich die hier beschriebene Verkapselung mit den ersten und zweiten Barrierenschichten eine kostengünstigere Herstellung und eine geringere Dicke der Verkapselung. Weiterhin kann es mit dem hier beschriebenen Verfahren möglich sein, ein elektronisches Bauelement mit einer transparenten Verkapselung herzustellen, was im Falle der Verkapselung mittels Deckglas und Gettermaterial nicht möglich ist.

Die Verfahrensschritte des Aufbringens der ersten Barrierenschicht und der zweiten Barrierenschicht können unmittelbar nacheinander in demselben Volumen, beispielsweise in einer herkömmlichen Beschichtungsanlage durchgeführt werden.

Die erste Barrierenschicht kann mittels des PEALD-Verfahrens beispielsweise mit einer Dicke von größer oder gleich 10 nm und kleiner oder gleich 30 nm aufgebracht werden. Das kann bedeuten, dass mittels des PEALD-Verfahrens die erste Barrierenschicht mit größer oder gleich 10 Monolagen und kleiner oder gleich 50 Monolagen herstellbar ist. Durch die hohe Dichte und Qualität der ersten Barrierenschicht kann eine solche Dicke ausreichend sein, um einen wirkungsvollen Schutz vor Feuchtigkeit und/oder Sauerstoff für die darunter liegende zumindest eine funktionelle Schicht zu gewährleisten. Obwohl das PEALD-Verfahren im Vergleich zum PECVD-Verfahren eine geringere Wachstumsrate aufweisen kann, kann aufgrund der geringen Dicke der ersten Barrierenschicht eine kurze Prozesszeit und damit eine hohe Wirtschaftlichkeit des hier beschriebenen Verfahrens gewährleistet sein.

Aufgrund der hohen Dichtigkeit der ersten Barrierenschicht können die Anforderungen an die zweite Barrierenschicht hinsichtlich Dichtigkeit geringer angesetzt werden als bei einer herkömmlichen Verkapselung mit Barrierenschichten, die alle mit CVD-Verfahren aufgebracht werden. Insbesondere kann die zweite Barrierenschicht mit einer höheren Wachstumsrate als die erste Barrierenschicht aufgebracht werden und nach dem Aufbringen eine Dicke von größer oder gleich 1nm und kleiner oder gleich 1000 nm aufweisen. Insbesondere kann die erste Barrierenschicht mit einer Dicke von größer oder gleich 10 nm, bevorzugt größer oder gleich 20 nm und besonders bevorzugt größer oder gleich 100 nm aufgebracht werden.

Das Verfahren weist einen weiteren Verfahrensschritt auf, bei dem eine Schutzschicht auf der ersten und zweiten Barrierenschicht aufgebracht wird. Dabei kann die Schutzschicht direkt auf der ersten oder zweiten Barrierenschicht aufgebracht werden und damit nach dem Aufbringen in direktem Kontakt mit der ersten oder der zweiten Barrierenschicht sein. Insbesondere kann die Schutzschicht einen mechanischen Schutz der darunter liegenden ersten und zweiten Barrierenschichten ermöglichen. Die Schutzschicht kann dazu mit einer Dicke von größer oder gleich 1 µm und kleiner oder gleich 100 µm aufgebracht werden. Insbesondere kann die Schutzschicht mit einer Dicke von größer oder gleich 5 µm und bevorzugt mit einer Dicke von größer oder gleich 10 µm aufgebracht werden.

Dabei weist die Schutzschicht Kunststoffe wie etwa Siloxane, Epoxide, Acrylate wie zum Beispiel Methylmethacrylate, Imide, Carbonate, Olefine, Styrole, Urethane oder Derivate davon in Form von Monomeren, Oligomeren oder Polymeren und weiterhin auch Mischungen, Copolymere oder Verbindungen damit auf. Beispielsweise kann die Schutzschicht ein Epoxidharz, Polymethylmethacrylat (PMMA), Polystyrol, Polycarbonat, Polyacrylat, Polyurethan oder ein Silikonharz wie etwa Polysiloxan oder Mischungen daraus umfassen oder sein. Die Schutzschicht kann dabei beispielsweise transparent sein.

Die Schutzschicht kann weiterhin einen Sprühlack aufweisen beziehungsweise als Sprühlack ausgebildet sein, der zumindest eines der vorher genannten Materialien umfasst und der beispielsweise mittels einer Durchlauf-Sprühbelackungsanlage aufgebracht werden kann. Der Sprühlack kann weiterhin ein UVhärtbarer und/oder ein binder- oder lösungsmittelhaltiger Sprühlack sein.

Das durch das hier beschriebene Verfahren herstellbare elektronische Bauelement kann als strahlungsemittierendes und/oder strahlungsempfangendes Bauelement und dabei als organisches oder anorganisches elektronisches Bauelement ausgebildet sein, etwa als anorganische lichtemittierende Diode (LED), organische lichtemittierende Diode (OLED), anorganische Photodiode (PD), organische Photodiode (OPD), anorganische Solarzelle (SC), organische Solarzelle (OSC), anorganischer Transistor, insbesondere anorganischer Dünnfilmtransistor (TFT), organischer Transistor, insbesondere organischer Dünnfilmtransistor (OTFT), oder als integrierter Schaltkreis (IC). Weiterhin kann das durch das hier beschriebene Verfahren herstellbare elektronische Bauelement eine Mehrzahl oder Kombination aus den genannten Elementen aufweisen oder derart ausgebildet sein.

Das elektronische Bauelement kann weiterhin nach der Herstellung eine funktionelle Schichtenfolge mit zumindest einer ersten und einer zweiten Elektrode aufweisen, zwischen denen die zumindest eine funktionelle Schicht umfassend eine oder mehrere anorganische und/oder organische funktionelle Schichten angeordnet sind. Insbesondere kann die funktionelle Schichtenfolge auf einem Substrat angeordnet sein.

Weist das Bauelement beispielsweise eine LED, eine OLED, eine PD, eine OPD, eine SC und/oder eine OSC auf, kann die funktionelle Schichtenfolge einen aktiven Bereich aufweisen, der geeignet ist, im Betrieb des elektronischen Bauelements elektromagnetische Strahlung zu erzeugen oder zu detektieren.

Bei einer besonders bevorzugten Ausführungsform wird bei dem hier beschriebenen Verfahren das elektronische Bauelement als organisches elektronisches Bauelement umfassend ein organisches strahlungsemittierendes Bauelement mit einer strahlungsemittierenden Schichtenfolge hergestellt. Die strahlungsemittierende Schichtenfolge kann dabei die als organische funktionelle Schicht ausgebildete funktionelle Schicht umfassen. Insbesondere kann das elektronische Bauelement dabei eine organische, strahlungsemittierende Diode (OLED) umfassen oder als solche ausgeführt sein. Das elektronische Bauelement kann dazu einen aktiven Bereich aufweisen, der geeignet ist, im Betrieb des elektronischen Bauelements durch Rekombination von Elektronen und Löchern elektromagnetische Strahlung abzustrahlen.

Eine organische strahlungsemittierende Schichtenfolge beziehungsweise eine OLED kann beispielsweise eine erste Elektrode auf dem Substrat aufweisen. Über der ersten Elektrode kann die zumindest eine organische funktionelle Schicht oder eine Mehrzahl von funktionellen Schichten aus organischen Materialien aufgebracht sein. Die zumindest eine organische funktionelle Schicht oder die Mehrzahl der funktionellen Schichten können dabei beispielsweise Elektronentransportschichten, elektrolumineszierende Schichten und/oder Lochtransportschichten aufweisen oder als solche ausgeführt sein. Über der organischen funktionellen Schicht oder der Mehrzahl organischer funktioneller Schichten kann eine zweite Elektrode aufgebracht sein.

Beispielsweise kann das Substrat Glas, Quarz, Kunststofffolien, Metall, Metallfolien, Siliziumwafer oder ein anderes geeignetes Substratmaterial umfassen. Ist die OLED als so genannter "Bottom-Emitter" ausgeführt, das heißt, dass die im aktiven Bereich erzeugte Strahlung durch das Substrat abgestrahlt wird, so kann das Substrat eine Transparenz für zumindest einen Teil der ersten Strahlung aufweisen.

In der Bottom-Emitter-Konfiguration kann vorteilhafterweise auch die erste Elektrode eine Transparenz für zumindest einen Teil der Primärstrahlung aufweisen. Eine transparente erste Elektrode, die als Anode ausgeführt sein kann und somit als Löcher-injizierendes Material dient, kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Die organische funktionelle Schicht oder die Mehrzahl funktioneller Schichten können organische Polymere, organische Oligomere, organische Monomere, organische kleine, nicht-polymere Moleküle ("small molecules") oder Kombinationen daraus aufweisen. Insbesondere kann es vorteilhaft sein, wenn die organische strahlungsemittierende Schichtenfolge eine funktionelle Schicht aufweist, die als Lochtransportschicht ausgeführt ist, um eine effektive Löcherinjektion in eine elektrolumineszierende Schicht oder einen elektrolumineszierenden Bereich zu ermöglichen. Als Materialien für eine Lochtransportschicht können sich beispielsweise tertiäre Amine, Carbazolderivate, leitendes Polyanilin oder Polyethylendioxythiophen als vorteilhaft erweisen. Weiterhin kann es vorteilhaft sein, wenn eine funktionelle Schicht als elektrolumineszierende Schicht ausgeführt ist. Als Materialien hierzu eignen sich Materialien, die eine Strahlungsemission aufgrund von Fluoreszenz oder Phosphoreszenz aufweisen, beispielsweise Polyfluoren, Polythiophen oder Polyphenylen oder Derivate, Verbindungen, Mischungen oder Copolymere davon. Abhängig von den Materialien in den funktionellen Schichten kann die erzeugte erste Strahlung einzelne Wellenlängen oder Bereiche oder Kombinationen daraus aus dem ultravioletten bis rotem Spektralbereich aufweisen.

Die zweite Elektrode kann als Kathode ausgeführt sein und somit als Elektronen-injizierendes Material dienen. Als Kathodenmaterial können sich unter anderem insbesondere Aluminium, Barium, Indium, Silber, Gold, Magnesium, Kalzium oder Lithium sowie Verbindungen, Kombinationen und Legierungen davon als vorteilhaft erweisen. Alternativ oder zusätzlich kann die zweite Elektrode auch eines der oben genannten TCOs aufweisen. Zusätzlich oder alternativ kann die zweite Elektrode auch transparent ausgeführt sein und/oder die erste Elektrode kann als Kathode und die zweite Elektrode als Anode ausgeführt sein. Das bedeutet insbesondere, dass die OLED auch als "Top-Emitter" ausgeführt sein kann.

Die erste und/oder die zweite Elektrode können jeweils großflächig ausgebildet sein. Dadurch kann im Falle einer OLED eine großflächige Abstrahlung der im aktiven Bereich erzeugten elektromagnetischen Strahlung ermöglicht werden. "Großflächig" kann dabei bedeuten, dass das elektronische Bauelement eine Fläche von größer oder gleich einigen Quadratmillimetern, bevorzugt größer oder gleich einem Quadratzentimeter und besonders bevorzugt größer oder gleich einem Quadratdezimeter aufweist. Alternativ oder zusätzlich können die erste und/oder die zweite Elektrode zumindest in Teilbereichen strukturiert ausgebildet sein. Dadurch kann eine strukturierte Abstrahlung der im aktiven Bereich erzeugten elektromagnetischen Strahlung ermöglicht werden, etwa in Form von Pixeln oder Piktogrammen.

Alternativ oder zusätzlich kann das elektronische Bauelement derart ausgebildet werden, dass das Substrat mit der zumindest einen als organische funktionelle Schicht ausgebildeten funktionellen Schicht einen Photodetektor und/oder einen Transistor umfasst oder als solcher ausgebildet ist.

Weiterhin kann das elektronische Bauelement als organisches elektronisches Bauelement umfassend eine organische Solarzelle oder Photodiode hergestellt werden. Das elektronische Bauelement kann dabei eine als organische funktionelle Schicht ausgebildete funktionelle Schicht aufweisen, die Merkmale der im Zusammenhang mit der OLED genannten funktionellen Schicht aufweist. Weiterhin kann das eine Solarzelle oder Photodiode umfassende elektronische Bauelement Elektroden mit Merkmalen der oben im Zusammenhang mit der OLED beschriebenen Elektroden aufweisen.

Weiterhin kann das elektronische Bauelement als anorganisches elektronisches Bauelement ausgebildet sein, das beispielsweise eine LED, PD, SC und/oder einen TFT umfasst. Dabei kann die zumindest eine funktionelle Schicht eine Epitaxieschichtenfolge, also eine epitaktisch gewachsene Halbleiterschichtenfolge, aufweisen oder als solche ausgeführt sein. Insbesondere kann die Halbleiterschichtenfolge beispielsweise einen III-V-Verbindungshalbleiter auf der Basis von InGaAlN, InGaAlP und/oder AlGAs und/oder eine II-VI-Verbindungshalbleiter mit einem oder mehreren der Elemente Be, Mg, Ca und Sr sowie einem oder mehreren der Element O, S und Se aufweisen. Beispielsweise gehören zu den II-VI-Verbindungshalbleitermaterialien ZnO, ZnMgO, CdS, ZnCdS und MgBeO. Weiterhin kann das anorganische elektronische Bauelement Elektroden mit Merkmalen der oben im Zusammenhang mit der OLED beschriebenen Elektroden aufweisen.

Die erste Barrierenschicht kann vor der zweiten Barrierenschicht auf die zumindest eine funktionelle Schicht aufgebracht werden. Dadurch kann durch die erste Barrierenschicht eine hochdichte, die funktionelle Schicht gleichmäßig bedeckende Oberfläche bereitgestellt werden, auf der dann die zweite Barrierenschicht aufgebracht wird. Durch die hervorragenden Oberflächeneigenschaften der ersten Barrierenschicht kann die Neigung der zweiten Barrierenschicht, Diffusionskanäle, Korngrenzen und/oder Poren auszubilden, verringert werden.

Insbesondere kann die erste Barrierenschicht direkt auf der oben genannten zweiten Elektrode beziehungsweise auf der strahlungsemittierenden oder strahlungsempfangenden Schichtenfolge aufgebracht werden. Durch das Aufbringen mittels des PEALD-Verfahrens kann die erste Barrierenschicht gleichmäßig dick und vollständig bedeckend auf dem Substrat mit der zumindest einen funktionellen Schicht beziehungsweise der funktionellen Schichtenfolge aufgebracht werden. Dadurch ist keine Planarisierungsschicht zwischen der funktionellen Schicht beziehungsweise der funktionellen Schichtenfolge und der Verkapselung erforderlich.

Alternativ kann vor dem Aufbringen der ersten Barrierenschicht die zweite Barrierenschicht aufgebracht werden. Dies kann insbesondere auch deshalb vorteilhaft sein, da beim Aufbringen der zweiten Barrierenschicht Korngrenzen, Kanäle und/oder Poren entstehen können, die durch die hochdichte zweite Barrierenschicht abgedichtet werden können.

Die erste Barrierenschicht und die zweite Barrierenschicht können jeweils ein Material aufweisen, das geeignet ist, die zumindest eine funktionelle Schicht vor schädigenden Einflüssen der Umgebung zu schützen, also etwa vor Sauerstoff und/oder Feuchtigkeit. Die erste Barriereschicht weist eines oder mehrere Materialien auf, die ausgewählt sind aus: Oxid mit Zinn, Zink, Titan, Zirkonium, Tantal, Niobium und/oder Hafnium; Nitrid mit Zinn, Zink, Titan, Zirkonium, Tantal, Niobium und/oder Hafnium; Oxinitrid mit Zinn, Zink, Titan, Zirkonium, Tantal, Niobium und/oder Hafnium; Indiumzinnoxid; Aluminiumzinkoxid. Beispielsweise kann als zweite Barrierenschicht ein Oxid, ein Nitrid oder ein Oxinitrid in kristalliner oder in glasartiger Form aufgebracht werden. Beispielsweise kann das Oxid, Nitrid oder Oxinitrid weiterhin Aluminium, Silizium, Zinn, Zink, Titan, Zirkonium, Tantal, Niobium oder Hafnium umfassen. Die erste und/oder die zweite Barrierenschicht kann dabei dielektrische oder auch elektrisch leitende Eigenschaften aufweisen und die zweite Barrierenschicht kann beispielsweise Siliziumoxid (SiOₓ), wie etwa SiO₂, Siliziumnitrid (SiₓN_{y}), wie etwa Si₂N₃, Siliziumoxynitrid (SiOₓN_{y}), Aluminiumoxid, etwa Al₂O₃, Aluminiumnitrid, Zinnoxid, Indiumzinnoxid, Zinkoxid oder Aluminiumzinkoxid aufweisen.

Zur Herstellung der ersten Barrierenschicht kann in dem oben beschriebenen PEALD-Verfahren als erste Ausgangsverbindung beispielsweise eine metallorganische oder eine halbmetallorganische Verbindung zugeführt werden. Als zweite Ausgangsverbindung, in dann das Plasma erzeugt wird, kann eine Sauerstoff- und/oder Stickstoff-haltige Verbindung zugeführt werden. Umfasst die erste Barrierenschicht rein beispielhaft etwa Al₂O₃, so kann als erste Ausgangsverbindung etwa Trimethylaluminium und als zweite Ausgangsverbindung N₂O zugeführt werden.

Die zweite Barrierenschicht weist weiterhin eine Schichtenfolge aus zumindest zwei Schichten mit unterschiedlichen Materialien auf. Das kann bedeuten, dass als zweite Barrierenschicht die Schichtenfolge mit zumindest zwei unterschiedlichen Schichten aufgebracht wird. Insbesondere weist die Schichtenfolge eine Schicht mit einem Oxid und eine Schicht mit einem Nitrid auf. Die Schichtenfolge kann auch eine Mehrzahl von ersten Schichten mit einem ersten Material, etwa einem Nitrid, und/oder eine Mehrzahl von zweiten Schichten mit einem zweiten Material, etwa einem Oxid, aufweisen, die abwechselnd aufeinander aufgebracht werden. Bezeichnet man die erste, nitridhaltige Schicht mit "N" und die zweite, oxidhaltige Schicht mit "O", so können die Schichtenfolge beispielsweise in einer Abfolge NON oder NONON oder auch ONO oder ONONO ausgebildet sein.

Weiterhin kann auf der zumindest einen ersten Barrierenschicht und/oder auf der zumindest einen zweiten Barrierenschicht eine weitere erste Barrierenschicht und/oder eine weitere zweite Barrierenschicht aufgebracht werden. Damit kann etwa eine Mehrzahl von ersten Barrierenschichten und/oder einer Mehrzahl von zweiten Barrierenschichten auf dem Substrat mit der zumindest einen organischen funktionellen Schicht aufgebracht werden. Die ersten Barrierenschichten und die zweiten Barrierenschichten können bevorzugt abwechselnd aufeinander aufgebracht werden.

Die weitere erste Barrierenschicht beziehungsweise die weitere zweite Barrierenschicht kann dabei zumindest eines oder mehrere Merkmale aufweisen, die im Zusammenhang mit der zumindest einen ersten beziehungsweise der zumindest einen zweiten Barrierenschicht beschrieben sind. Insbesondere kann jede weitere erste Barrierenschicht mittels eines PEALD-Verfahrens aufgebracht werden, während jede weitere zweite Barrierenschicht mittels eine PECVD-Verfahrens aufgebracht werden kann.

Gemäß einer weiteren Ausführungsform wird mittels des hier beschriebenen Verfahrens ein elektronisches Bauelement hergestellt. Das elektronische Bauelement kann insbesondere ein Substrat mit zumindest einer funktionellen Schicht und darüber zumindest eine erste Barrierenschicht und zumindest eine zweite Barrierenschicht aufweisen. Die zumindest eine erste Barrierenschicht und die zumindest eine zweite Barrierenschicht können dabei jeweils eines oder mehrere der oben beschriebenen Merkmale aufweisen. Das elektronische Bauelement kann sich dabei durch eine geringe Dicke bei gleichzeitiger hoher Dichtigkeit der Verkapselung auszeichnen, das mit hoher Wirtschaftlichkeit hergestellt werden kann.

Weitere Vorteile und vorteilhafte Ausführungsformen und Weiterbildungen der Erfindung ergeben sich aus den im Folgenden in Verbindung mit den Figuren 1A bis 5 beschriebenen Ausführungsformen.

Es zeigen:
- Figuren 1A bis 1C: schematische Darstellungen eines Verfahrens gemäß einem Ausführungsbeispiel,
- Figur 2: eine schematische Darstellung eines organischen elektronischen Bauelements, das mittels eines Verfahrens gemäß einem weiteren Ausführungsbeispiel herstellbar ist, und
- Figuren 3 bis 5: schematische Darstellungen von Ausschnitten elektronischer Bauelemente, die mittels Verfahren gemäß weiteren Ausführungsbeispielen herstellbar sind.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

In den folgenden Figuren sind rein beispielhaft Ausführungsbeispiele zur Herstellung von elektronischen Bauelementen sowie Ausführungsbeispiele von elektronischen Bauelementen gezeigt, die als organische elektronische Bauelemente umfassend eine OLED ausgeführt sind. Es sei ausdrücklich darauf hingewiesen, dass die im Folgenden beschriebenen Verfahren, Bauelemente und Merkmale davon auch für die anderen im allgemeinen Teil beschriebenen elektronischen Bauelemente gelten.

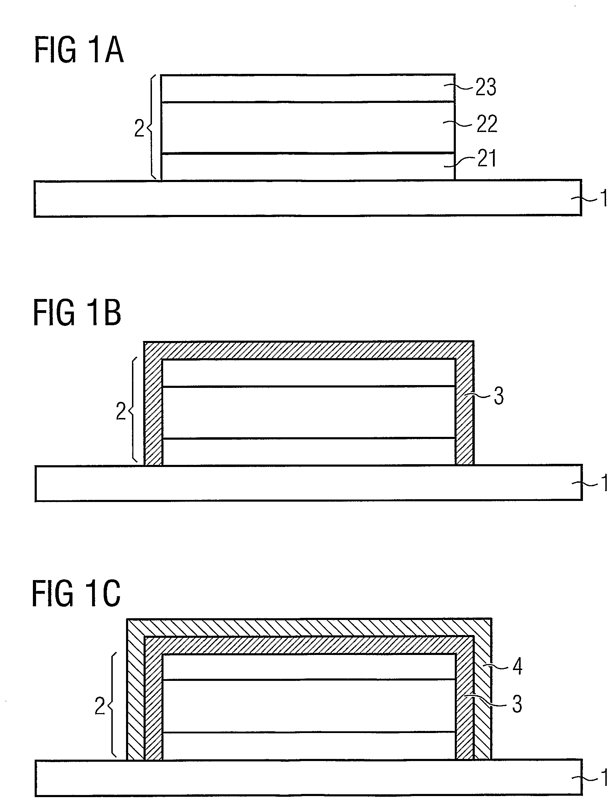

In den Figuren 1A bis 1C ist ein Verfahren zur Herstellung eines organischen elektronischen Bauelements gemäß einem Ausführungsbeispiel gezeigt (nicht Teil dieser Erfindung).

In einem ersten Verfahrensschritt gemäß Figur 1A wird ein Substrat 1 mit zumindest einer organischen funktionellen Schicht 22 bereitgestellt. Die organische funktionelle Schicht 22 ist dabei Teil einer organischen Schichtenfolge 2 und ist zwischen einer ersten Elektrode 21 und einer zweiten Elektrode 23 eingebettet. Das Substrat 1 mit der organischen Schichtenfolge 2 ist dabei als organische lichtemittierende Diode (OLED) ausgebildet und kann weitere funktionelle Schichten wie oben im allgemeinen Teil beschrieben aufweisen (nicht gezeigt). Die elektrische Ankontaktierung der ersten und zweiten Elektrode 21, 23 erfolgt über Leiterbahnen, die der Übersichtlichkeit halber nicht gezeigt sind.

Das Substrat 1 mit der organischen Schichtenfolge 2 ist im gezeigten Ausführungsbeispiel als Bottom-Emitter ausgeführt und weist ein transparentes Substrat 1 aus Glas sowie eine transparente erste Elektrode 21 aus ITO auf, die als Anode ausgebildet ist. Die zweite Elektrode 23 ist reflektierend und als Kathode ausgebildet und weist Aluminium auf.

In einem weiteren Verfahrensschritt gemäß Figur 1B wird mittels eines PEALD-Verfahrens eine erste Barrierenschicht 3 aus Al₂O₃ auf der organischen funktionellen Schicht 22 und insbesondere auf der Schichtenfolge 2 aufgebracht. Dazu wird das Substrat 1 mit der organischen Schichtenfolge 2 in einer Beschichtungsanlage auf eine Temperatur von weniger als 100°C und bevorzugt weniger als 80°C aufgeheizt und in einem ersten Teilschritt Trimethylaluminium als eine erste Ausgangsverbindung ausgesetzt, so dass das Trimethylaluminium auf der durch die Schichtenfolge 2 und das Substrat 1 gebildeten Oberfläche adsorbieren kann. Um eine Adsorption der ersten Ausgangsverbindung beispielsweise auf einem Kontaktbereich des Substrats 1 zur späteren elektrischen Kontaktierung des organische elektronischen Bauelements zu vermeiden kann beispielsweise eine den Kontaktbereich bedeckende Maskenschicht verwendet werden, die nach dem Aufbringen der ersten Barrierenschicht wieder entfernt werden kann. Nach dem Entfernen des nicht adsorbierten Anteils des Trimethylaluminiums wird in einem zweiten Teilschritt des PEALD-Verfahrens das Substrat 1 mit dem Schichtenstapel 2 einem Plasma mit N₂O als zweite Ausgangsverbindung ausgesetzt. Das N₂O kann mit dem auf dem Substrat 1 und der Schichtenfolge 2 adsorbierten Trimethylaluminium zu einer AL₂O₃-Schicht mit einer Dicke im Bereich von weniger als 1 nm bis zu mehreren Nanometern reagieren, die aber bevorzugt als Monolage ausgebildet ist. Der erste und der zweite Teilschritt des PEALD-Verfahrens werden sooft wiederholt, bis eine 10 bis 30 nm dicke erste Barrierenschicht 3 hergestellt ist.

Durch das PEALD-Verfahren kann eine hochdichte erste Barrierenschicht 3 hergestellt werden, die sich durch eine hervorragende Kristallstruktur auszeichnet und im Vergleich zu einer mittels eines CVD-Verfahrens aufgewachsenen Schicht keine oder nur kaum Poren und/oder Kanäle aufweist. Weiterhin ermöglicht die derart hergestellte erste Barrierenschicht 3 eine hochdichte Grenzfläche zwischen der Barrierenschicht 3 und beispielsweise dem Substrat 1 im Randbereich der Verkapselung, wodurch mögliche Permeationspfade für Sauerstoff und/oder Feuchtigkeit entlang dieser Grenzflächen vermieden werden.

In einem weiteren Verfahrensschritt gemäß Figur 1C wird mittels eines PECVD-Verfahrens zweite Barrierenschicht 4 aus SiO₂ auf der ersten Barrierenschicht 3 aufgebracht. Die zweite Barrierenschicht 4 wird dabei mit einer Dicke von etwa 100 nm bis etwa 1000 nm bei derselben Temperatur wie die erste Barrierenschicht 3 aufgebracht. Aufgrund der hochdichten ersten Barrierenschicht 3 kann die zweite Barrierenschicht 4 mit einer im Vergleich höheren Aufwachsrate aufgebracht werden, um eine intrinsisch dichte Verkapselung der organischen Schichtenfolge 2 zu erreichen.

Insgesamt wird so eine hochdichte Verkapselung bei kurzen Prozesszeiten in einem wirtschaftlichen Verfahren erreicht.

Das PEALD-Verfahren und das PECVD-Verfahren werden in derselben Beschichtungsanlage durchgeführt, so dass bei der Herstellung der Verkapselung mit der ersten Barrierenschicht 3 und der zweiten Barrierenschicht 4 keine zusätzlichen Totzeiten durch Be- und Entladen von Beschichtungsanlagen beim Wechseln vom PEALD-Verfahren zum PECVD-Verfahren entstehen.

Alternativ oder zusätzlich zu den hier beschriebenen Materialien kann die erste und/oder die zweite Barrierenschicht 3, 4 Oxide, Nitride und/oder Oxinitride mit Halbmetallen und/oder Metallen wie im allgemeinen Teil ausgeführt aufweisen. Alternativ zum gezeigten Verfahren kann die zweite Barrierenschicht 4 auch vor der ersten Barrierenschicht 3 auf dem Substrat und dem organischen Schichtenstapel 2 mit der organischen funktionellen Schicht 22 aufgebracht werden.

Alternativ oder zusätzlich kann die zweite Elektrode 23 transparent ausgeführt sein, so dass das organische elektronische Bauelement als Top-Emitter oder als transparente OLED hergestellt werden kann. Alternativ oder zusätzlich kann die Schichtenfolge 2 beispielsweise auch einen organischen Transistor und/oder eine organische Photodiode umfassen oder sein.

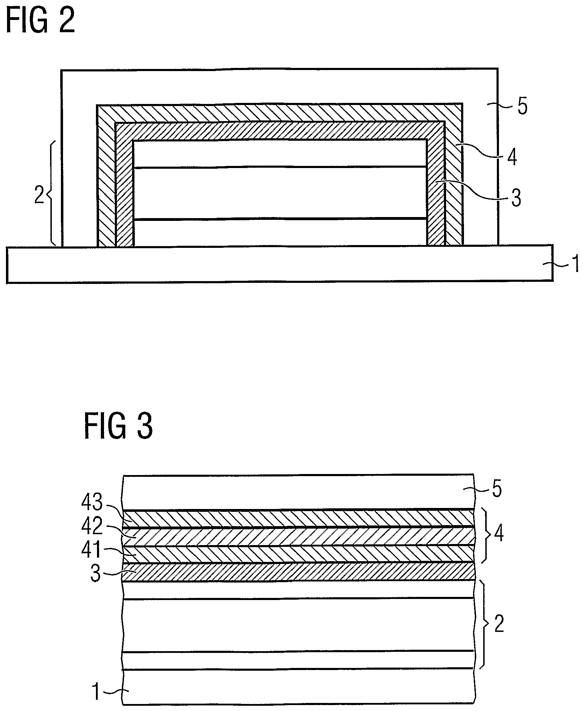

In Figur 2 ist ein Ausführungsbeispiel für ein organisches elektronisches Bauelement gezeigt, dass mittels eines Verfahrens hergestellt ist, das im Vergleich zum Verfahren gemäß dem vorherigen Ausführungsbeispiel einen weiteren Verfahrensschritt aufweist.

Dabei wird nach dem oben beschriebenen Aufbringen der ersten und zweiten Barrierenschicht 3, 4 weiterhin eine Schutzschicht 5 aufgebracht. Die Schutzschicht 5 umfasst einen Sprühlack, der beispielsweise ein lösungsmittelhaltiger Lack sein kann, der mit einer Dicke von 10 bis 100 µm in einer Durchlauf-Sprühbelackungsanlage aufgebracht wird. Durch die Schutzschicht 5 kann das organische elektronische Bauelement und insbesondere die erste und zweite Barrierenschicht 3, 4 wirksam gegen Kratzer und sonstige mechanische Beschädigungen geschützt werden.

Alternativ oder zusätzlich kann als Schutzschicht 5 beispielsweise auch ein Polymer, etwa ein Silikon- oder Epoxidharz aufgebracht werden.

In den folgenden Figuren sind Ausschnitte von organischen elektronischen Bauelementen gemäß weiterer Ausführungsbeispiele gezeigt, die Modifikationen und Variationen der vorherigen Ausführungsbeispiele darstellen. Die nachfolgende Beschreibung bezieht sich hauptsächlich auf die Unterschiede zu den vorherigen Ausführungsbeispielen.

In Figur 3 ist ein Ausschnitt eines organischen elektronischen Bauelements gezeigt (nicht Teil dieser Erfindung), bei dem wie in den vorhergehenden Ausführungsbeispielen über der Schichtenfolge 2 eine hochdichte erste Barrierenschicht 3 aus Al₂O₃ aufgebracht ist. Darüber ist eine zweite Barrierenschicht 4 mittels eines PECVD-Verfahrens aufgebracht, die drei Schichten 41, 42, 43 mit einer Gesamtdicke von 100 bis 100 nm aufweist. Die Schichten 41 und 43 sind als Siliziumnitridschicht ausgeführt, während die Schicht 42 als Siliziumoxidschicht ausgeführt ist. Alternativ können die Materialien der Schichten 41, 43 und der Schicht 42 auch vertauscht sein. Weiterhin kann die zweite Barrierenschicht 4 auch beispielsweise eine Schichtenfolge mit fünf Schichten aufweisen, die abwechselnd als Siliziumoxid- und Siliziumnitridschichten ausgebildet sind.

Alternativ zum gezeigten Ausführungsbeispiel kann die erste Barrierenschicht 3 auch auf der zweiten Barrierenschicht 4 mit den Schichten 41, 42, 43 aufgebracht sein.

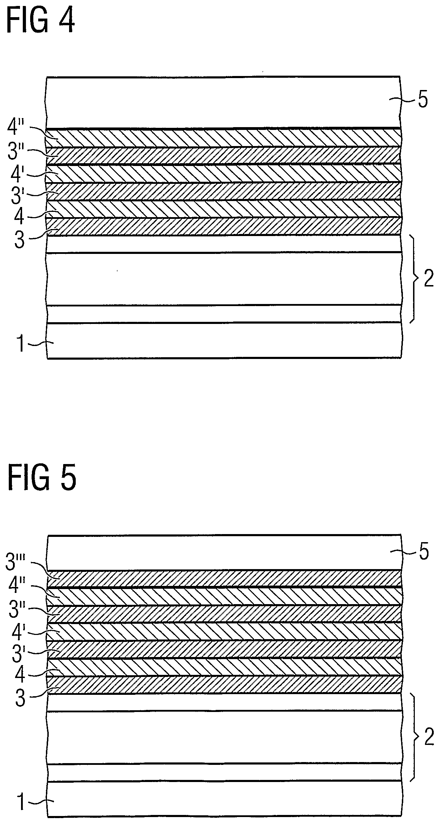

In den Figuren 4 und 5 sind Ausschnitte von organischen elektronischen Bauelementen gezeigt, die eine Mehrzahl von ersten Barrierenschichten 3, 3', 3" beziehungsweise 3, 3', 3", 3'" und eine Mehrzahl von zweiten Barrierenschichten 4, 4', 4" aufweisen, die jeweils abwechselnd aufeinander mittels PEALD-Verfahren beziehungsweise PECVD-Verfahren aufgebracht sind. Da nicht ausgeschlossen werden kann, dass die zweite Elektrode der Schichtenfolge 2 und/oder die zweiten Barrierenschichten 4, 4', 4" zumindest teilweise Defekte beispielsweise in Form von kolumnaren Wachstum, Kanälen, Poren und/oder Korngrenzen aufweisen, kann durch die ersten Barrierenschichten 3, 3', 3" zwischen der Schichtenfolge 2 und den zweiten Barrierenschichten 4, 4', 4" sichergestellt werden, dass eine Fortsetzung solcher Defekte wirksam unterbrochen werden kann. Insbesondere können in den zweiten Barrierenschichten 4, 4', 4" auftretende Kanäle und/oder Poren durch die darüber liegenden ersten Barrierenschichten 3', 3" beziehungsweise 3', 3", 3''' abgedichtet werden.

Weiterhin kann zumindest eine der zweiten Barrierenschichten 4, 4' und 4" mehrere Schichten wie in Verbindung mit dem Ausführungsbeispiel in Figur 3 gezeigt aufweisen.

Die Erfindung ist nicht durch die Beschreibung anhand der Ausführungsbeispiele auf diese beschränkt.

## Patentansprüche

1. Verfahren zur Herstellung eines elektronischen Bauelements mit Barrierenschichten zur Verkapselung des Bauelements, mit den Schritten:
- Bereitstellen eines Substrats (1) mit zumindest einer funktionellen Schicht (22),
- Aufbringen zumindest einer ersten Barrierenschicht (3) auf der funktionellen Schicht (22) mittels plasmaunterstützter Atomschichtenabscheidung (PEALD), wobei die erste Barriereschicht (3) eines oder mehrere Materialien aufweist, die ausgewählt sind aus:
- Oxid mit Zinn, Zink, Titan, Zirkonium, Tantal, Niobium und/oder Hafnium,
- Nitrid mit Zinn, Zink, Titan, Zirkonium, Tantal, Niobium und/oder Hafnium,
- Oxinitrid mit Zinn, Zink, Titan, Zirkonium, Tantal, Niobium und/oder Hafnium,
- Indiumzinnoxid,
- Aluminiumzinkoxid,
und
- Aufbringen zumindest einer zweiten Barrierenschicht (4) auf der funktionellen Schicht (22) mittels plasmaunterstützter chemischer Gasphasenabscheidung (PECVD), wobei als zweite Barrierenschicht (4) eine Schichtenfolge aus zumindest zwei Schichten (41, 42) mit unterschiedlichen Materialien aufgebracht wird und die zumindest zwei Schichten (41, 42) mit unterschiedlichen Materialien eine Schicht mit einem Oxid und eine Schicht mit einem Nitrid umfassen,
- Aufbringen einer Schutzschicht (5) auf der ersten und zweiten Barrierenschicht (3, 4), die einen Kunststoff aufweist.

2. Verfahren nach Anspruch 1, bei dem
- die Schutzschicht (5) mit einer Dicke von größer oder gleich 5 µm aufgebracht wird.

3. Verfahren nach dem einem der vorherigen Ansprüche, bei dem
- die Schutzschicht (5) einen Sprühlack aufweist.

4. Verfahren nach einem der vorherigen Ansprüche, bei dem
- beim Bereitstellen des Substrats (1) mit der zumindest einen funktionellen Schicht (22) eine erste Elektrode (21) auf dem Substrat (1) und eine zweite Elektrode (23) auf der zumindest einen funktionellen Schicht (22) aufgebracht wird,
- die funktionelle Schicht (22) eine organische funktionelle Schicht umfasst und
- die erste Barrierenschicht (3) auf der zweiten Elektrode (23) aufgebracht wird.

5. Verfahren nach einem der vorherigen Ansprüche, bei dem
- zumindest eine weitere erste Barrierenschicht (3') und/oder zumindest eine weitere zweite Barrierenschicht (4') aufgebracht wird.

6. Verfahren nach Anspruch 5, bei dem
- die ersten und zweiten Barrierenschichten (3, 3', 4, 4') abwechselnd aufeinander aufgebracht werden.

7. Verfahren nach einem der vorherigen Ansprüche, bei dem
- die zweite Barrierenschicht (4) vor der ersten Barrierenschicht (3) aufgebracht wird.

8. Verfahren nach einem der vorherigen Ansprüche, bei dem
- die zumindest eine erste Barrierenschicht (3) und die zumindest eine zweite Barrierenschicht (4) bei einer Temperatur von kleiner als 120°C aufgebracht werden.

9. Verfahren nach einem der vorherigen Ansprüche, bei dem
- die zumindest eine erste Barrierenschicht (3) eine Dicke von größer oder gleich 10 nm und kleiner oder gleich 30 nm aufweist.

10. Verfahren nach einem der vorherigen Ansprüche, bei dem
- die zumindest eine zweite Barrierenschicht (4) eine Dicke von größer oder gleich 100 nm und kleiner oder gleich 1000 nm aufweist.

11. Verfahren nach einem der vorherigen Ansprüche, bei dem
- das elektronische Bauelement eine lichtemittierende organische Diode (OLED) und/oder eine Solarzelle umfasst.

## Claims

1. A method for producing an electronic component comprising barrier layers for the encapsulation of the component, comprising the following steps:
- providing a substrate (1) with at least one functional layer (22),
- applying at least one first barrier layer (3) on the functional layer (22) by means of plasma-enhanced atomic layer deposition (PEALD), wherein the first barrier layer (3) comprises one or more materials chosen from:
- oxide with tin, zinc, titanium, zirconium, tantalum, niobium and/or hafnium,
- nitride with tin, zinc, titanium, zirconium, tantalum, niobium and/or hafnium,
- oxynitride with tin, zinc, titanium, zirconium, tantalum, niobium and/or hafnium,
- indium tin oxide,
- aluminum zinc oxide,
and
- applying at least one second barrier layer (4) on the functional layer (22) by means of plasma-enhanced chemical vapor deposition (PECVD), a layer sequence composed of at least two layers (41, 42) comprising different materials is applied as the second barrier layer (4) and the at least two layers (41, 42) comprising different materials comprise a layer comprising an oxide and a layer comprising a nitride,
- applying a protective layer (5) comprising a plastic material on the first and second barrier layers (3, 4).

2. The method according to claim 1, wherein
- the protective layer (5) is applied with a thickness of greater than or equal to 5 µm.

3. The method as claimed in any of the preceding claims, wherein
- the protective layer (5) comprises a spray coating.

4. The method as claimed in any of the preceding claims, wherein
- in the course of providing the substrate (1) with the at least one functional layer (22), a first electrode (21) is applied on the substrate (1) and a second electrode (23) is applied on the at least one functional layer (22),
- the functional layer (22) comprises an organic functional layer and
- the first barrier layer (3) is applied on the second electrode (23).

5. The method as claimed in any of the preceding claims, wherein
- at least one further first barrier layer (3') and/or at least one further second barrier layer (4') is applied.

6. The method as claimed in claim 5, wherein
- the first and second barrier layers (3, 3', 4, 4') are applied alternately one on top of another.

7. The method as claimed in any of the preceding claims, wherein
- the second barrier layer (4) is applied before the first barrier layer (3).

8. The method as claimed in any of the preceding claims, wherein
- the at least one first barrier layer (3) and the at least one second barrier layer (4) are applied at a temperature of less than 120°C.

9. The method as claimed in any of the preceding claims, wherein
- the at least one first barrier layer (3) has a thickness of greater than or equal to 10 nm and less than or equal to 30 nm.

10. The method as claimed in any of the preceding claims, wherein
- the at least one second barrier layer (4) has a thickness of greater than or equal to 100 nm and less than or equal to 1000 nm.

11. The method as claimed in any of the preceding claims, wherein
- the electronic component comprises an organic light emitting diode (OLED) and/or a solar cell.

## Revendications

1. Procédé de fabrication d'un composant électronique présentant des couches barrières visant à encapsuler le composant, comprenant les étapes suivantes :
- mise en place d'un substrat (1) présentant au moins une couche fonctionnelle (22),
- application d'au moins une première couche barrière (3) sur la couche fonctionnelle (22) par dépôt par couche atomique assistée par plasma (PEALD), la première couche barrière (3) comprenant un ou plusieurs matériaux choisis parmi :
- oxyde avec étain, zinc, titane, zirconium, tantale, niobium et/ou hafnium,
- nitrure avec étain, zinc, titane, zirconium, tantale, niobium et/ou hafnium,
- oxynitrure avec étain, zinc, titane, zirconium, tantale, niobium et/ou hafnium,
- oxyde d'indium-étain,
- oxyde d'aluminium et de zinc,
et
- application d'au moins une deuxième couche barrière (4) sur la couche fonctionnelle (22) au moyen d'un dépôt chimique en phase vapeur assisté par plasma (PECVD), une succession de couches comprenant au moins deux couches (41, 42) de matériaux différents étant appliquée en tant que deuxième couche barrière (4) et au moins deux couches (41, 42) de matériaux différents comprenant une couche avec un oxyde et une couche avec un nitrure,
- application d'une couche protectrice (5) sur les première et deuxième couches barrières (3, 4), comprenant une matière plastique.

2. Procédé selon la revendication 1, dans lequel
- la couche protectrice (5) est appliquée dans une épaisseur supérieure ou égale à 5 µm.

3. Procédé selon l'une des revendications précédentes, dans lequel
- la couche protectrice (5) présente une peinture aérosol.

4. Procédé selon l'une des revendications précédentes, dans lequel
- lors de la mise en place du substrat (1) avec au moins une couche fonctionnelle (22), une première électrode (21) est posée sur le substrat (1) et une seconde électrode (23) est posée sur au moins une couche fonctionnelle (22),
- la couche fonctionnelle (22) comprend une couche fonctionnelle organique, et
- la première couche barrière (3) est appliquée sur la seconde électrode (23).

5. Procédé selon l'une des revendications précédentes, dans lequel
- au moins une première couche barrière supplémentaire (3') et/ou au moins une deuxième couche barrière supplémentaire (4') est appliquée.

6. Procédé selon la revendication 5, dans lequel
- les première et deuxième couches barrières (3, 3', 4, 4') sont appliquées alternativement l'une sur l'autre.

7. Procédé selon l'une des revendications précédentes, dans lequel
- la deuxième couche barrière (4) est appliquée avant la première couche barrière (3).

8. Procédé selon l'une des revendications précédentes, dans lequel
- au moins une première couche barrière (3) et au moins une deuxième couche barrière (4) sont appliquées à une température inférieure à 120°C.

9. Procédé selon l'une des revendications précédentes, dans lequel
- au moins une première couche barrière (3) présente une épaisseur supérieure ou égale à 10 nm et inférieure ou égale à 30 nm.

10. Procédé selon l'une des revendications précédentes, dans lequel
- au moins une deuxième couche barrière (4) présente une épaisseur supérieure ou égale à 100 nm et inférieure ou égale à 1000 nm.

11. Procédé selon l'une des revendications précédentes, dans lequel
- le composant électronique comprend une diode électroluminescente organique (OLED) et/ou une cellule photovoltaïque.
